Europäisches Patentamt

European Patent Office

Office européen des brevets

(11) Veröffentlichungsnummer: **0 134 468**

**A2**

(12) # EUROPÄISCHE PATENTANMELDUNG

(21) Anmeldenummer: **84107735.7**

(22) Anmeldetag: **04.07.84**

(51) Int. Cl.⁴: **H 03 G 3/30**

(30) Priorität: **19.07.83 DE 3325926**

(43) Veröffentlichungstag der Anmeldung
**20.03.85 Patentblatt 85/12**

(84) Benannte Vertragsstaaten:
**FR GB IT SE**

(71) Anmelder: **TELEFUNKEN electronic GmbH**
**Theresienstrasse 2**
**D-7100 Heilbronn(DE)**

(72) Erfinder: **Moser, Helmut, Dipl.-Ing. (FH)**
**Breslauer Strasse 53**
**D-7100 Heilbronn(DE)**

(72) Erfinder: **Militzer, Karl, Ing. grad.**
**Breslauer Strasse 55**
**D-7100 Heilbronn(DE)**

(74) Vertreter: **Maute, Hans-Jürgen, Dipl.-Ing.**
**TELEFUNKEN electronic GmbH Theresienstrasse 2**
**D-7100 Heilbronn(DE)**

(54) **Empfangsverstärker zur Verstärkung eines Photostromes.**

(57) Bei einem Empfangsverstärker zur Verstärkung eines Photostromes mit einem lichtempfindlichen Halbleiterbauelement, insbesondere Photodiode, und einem Verstärkertransistor ist zwischen das lichtempfindliche Halbleiterbauelement (FD) und den Verstärkertransistor (T2) eine Koppelkapazität ($C_k$) geschaltet, die derart bemessen ist, daß sie vom lichtempfindlichen Halbleiterbauelement gelieferte Signale mit einer unterhalb einer bestimmten Schwelle liegenden Frequenz vom Verstärkertransistor (T2) fernhält, wobei ein Transistor (T1) zur Gegenkopplung vorgesehen ist, der einen solchen Strom liefert, daß dieser Strom eine von Lichtimpulsen am lichtempfindlichen Halbleiterbauelement hervorgerufene Stromänderung kompensiert.

FIG. 1

EP 0 134 468 A2

TELEFUNKEN electronic GmbH
Theresienstr. 2, 7100 Heilbronn

0134468

Heilbronn, 06.07.83
La/ra    -  HN 82/21

Empfangsverstärker zur Verstärkung
eines Photostromes

Die Erfindung betrifft einen Empfangsverstärker zur
Verstärkung eines Photostromes mit einem lichtempfindlichen Halbleiterbauelement, insbesondere Photodiode,
und einem Verstärkertransistor.

Bekannte Infrarot-Empfangsverstärker arbeiten in der
Regel mit Versorgungsspannungen, die größer als 12 Volt
sind. Dadurch erhält man für die Infrarot-Empfangsdiode - die in Sperrichtung betrieben wird - eine Vorspannung, die die Kapazität der Empfangsdiode so weit
reduziert, daß die Übertragung auch kurzer IR-Impulse
bis herab zu 10 µsec möglich wird. Bekannte Schaltungen,
die mit niedriger Versorgungsspannung arbeiten (z. B.
5 V) haben den Nachteil, daß der Arbeitswiderstand der
Schaltung sehr niederohmig sein muß, wenn die Umgebungshelligkeit relativ groß sein kann.

Der Erfindung liegt die Aufgabe zugrunde, einen Empfangsverstärker zur Verstärkung von Photoströmen anzugeben, der die Möglichkeit bietet, trotz niedriger
Versorgungsspannung von z. B. 5 Volt bei hoher Umgebungshelligkeit mit einem relativ großen Arbeitswiderstand kurze Lichtimpulse, beispielsweise IR-Impulse, zu
verarbeiten. Diese Aufgabe wird bei einem Empfangsverstärker der eingangs erwähnten Art nach der Erfindung
dadurch gelöst, daß zwischen das lichtempfindliche

- 2 -

0134468

Halbleiterbauelement und den Verstärkertransistor eine Koppelkapazität geschaltet ist, die derart bemessen ist, daß sie vom lichtempfindlichen Halbleiterbauelement gelieferte Signale mit einer unterhalb einer bestimmten Schwelle liegenden Frequenz vom Verstärkertransistor fernhält, und daß ein Transistor zur Gegenkopplung vorgesehen ist, der einen solchen Strom liefert, daß dieser Strom eine von Lichtimpulsen am lichtempfindlichen Halbleiterbauelement hervorgerufene Stromänderung kompensiert.

Der Verstärker nach der Erfindung ermöglicht die Verwendung von Arbeitswiderständen, die größer als 300 KOhm sind, und verarbeitet Lichtimpulse mit einer Dauer, die kleiner als 5 μsec ist.

Gemäß einer Weiterbildung der Erfindung ist ein Transistor vorgesehen, der zur Kompensation der Kollektor-Basis-Kapazität dient. Dieser Transistor ist emitterseitig mit dem Kollektor des Verstärkertransistors und kollektorseitig mit der Basis des Gegenkopplungs-Transistors verbunden. Der Emitter des Gegenkopplungs-Transistors ist über einen Widerstand mit der Koppelkapazität verbunden.

Die Erfindung wird im folgenden an einem Ausführungsbeispiel näher erläutert.

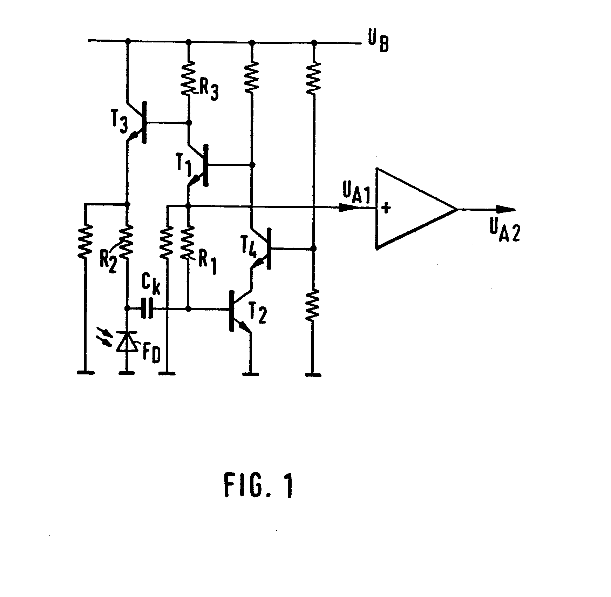

Die Figur 1 zeigt einen Verstärker für Infrarotlicht. Die Infrarot-Diode (FD), die Infrarotlicht in einen entsprechenden Photostrom umwandelt, befindet sich bei der Schaltung der Figur 1 im Vorverstärker. Langsame Änderungen der im Bereich der Photodiode herrschenden Helligkeit machen sich an der Basis des Verstärker-

Transistors (T2) nicht bemerkbar, da der langsamen Helligkeitsänderung entsprechende Photostrom (Anteil) von der Koppelkapazität ($C_k$) nicht auf die Basis des Transistors T2 übertragen wird. Da der Quasi-Gleichstromanteil des Photostromes im vorliegenden Fall wegen entsprechender Bemessung des Koppelkondensators $C_k$ nicht an die Basis des Transistors T2 gelangen kann, fließt er von der Photodiode (FD) über den Widerstand R2 und den R2 nachgeschalteten Transistor T3. Treffen dagegen kurze IR-Impulse (Infrarot-Impulse) auf die Photodiode (FD), so werden von der Photodiode (FD) entsprechend kurze Stromimpulse erzeugt, die über die Kapazität $C_k$ an die Basis des Transistors T2 gelangen. Der Transistor T1 der Vorverstärkerstufe, dessen Kollektor mit der Basis des Transistors T3 und über einen Widerstand R3 mit dem Betriebspotential verbunden ist und dessen Emitterelektrode als Ausgang der Vorverstärkerstufe dient, bewirkt eine Gegenkopplung. Der Transistor T4, dessen Emitter mit dem Kollektor des Transistors T2 und dessen Kollektor mit der Basis des Transistors T1 verbunden ist, hat die Aufgabe, die Kollektor-Basis-Kapazität des Transistors T2 zu kompensieren.

Die hohe Verstärkung der aus den Transistoren T2, T4 und T1 bestehenden Anordnung bewirkt bei einer Einwirkung von Lichtimpulsen auf die Photodiode (FD) eine Gegenkopplung mit dem Ergebnis, daß der verstärkte Spannungssprung am Emitter des Transistors T1 über den Widerstand R1 einen Strom fließen läßt, der die durch IR-Impulse an der Photodiode hervorgerufenen Stromimpulse kompensiert. Infolge dieser Kompensation bleibt die Spannung an der Photodiode nahezu konstant, so daß deren Sperrschichtkapazität nicht umgeladen werden muß. Daraus resultiert die Möglichkeit, kurze Stromimpulse, die durch kurze IR-Impulse ausgelöst werden, zu übertragen.

Da die aus den Transistoren T2, T4 und T1 bestehende Anordnung nur eine endlich große Verstärkung aufweist, ist für den Stromfluß über den Widerstand R1 eine $U_{BE}$-Änderung am Transistor T2 erforderlich. Diese $U_{BE}$-Änderung wird durch den Spannungshub am Widerstand R3 mit Hilfe des Transistors T3 kompensiert. Der Transistor T4 dient ausschließlich zur Kompensation der Kollektor-Basis-Kapazität des Transistors T2.

Heilbronn, 06.07.83
La/ra    -   HN 82/21

Patentansprüche

1) Empfangsverstärker zur Verstärkung eines Photostromes mit einem lichtempfindlichen Halbleiterbauelement, insbesondere Photodiode, und einem Verstärkertransistor, dadurch gekennzeichnet, daß zwischen das lichtempfindliche Halbleiterbauelement (FD) und den Verstärkertransistor (T2) eine Koppelkapazität ($C_k$) geschaltet ist, die derart bemessen ist, daß sie vom lichtempfindlichen Halbleiterbauelement gelieferte Signale mit einer unterhalb einer bestimmten Schwelle liegenden Frequenz vom Verstärkertransistor (T2) fernhält, und daß ein Transistor (T1) zur Gegenkopplung vorgesehen ist, der einen solchen Strom liefert, daß dieser Strom eine von Lichtimpulsen am lichtempfindlichen Halbleiterbauelement hervorgerufene Stromänderung kompensiert.

2) Empfangsverstärker nach Anspruch 1, dadurch gekennzeichnet, daß ein Transistor (T4) vorgesehen ist, der zur Kompensation der Kollektor-Basis-Kapazität des Verstärkertransistors (T2) dient.

3) Empfangsverstärker nach Anspruch 2, dadurch gekennzeichnet, daß der zur Kompensation vorgesehene Transistor (T4) emitterseitig mit dem Kollektor des Verstärkertransistors (T2) und kollektorseitig mit der Basis des Gegenkopplungs-Transistors (T1) verbunden ist.

4) Empfangsverstärker nach einem der Ansprüche 1 bis 3, dadurch gekennzeichnet, daß der Emitter des Gegenkopplungs-Transistors (T1) über einen Widerstand (R1) mit der Koppelkapazität ($C_k$) verbunden ist.

5) Empfangsverstärker nach einem der Ansprüche 1 bis 4, dadurch gekennzeichnet, daß zwischen dem lichtempfindlichen Halbleiterbauelement (FD) und dem Betriebspotential die Reihenschaltung eines Widerstandes (R2) mit der Emitter-Kollektorstrecke eines Transistors (T3) liegt.

6) Empfangsverstärker nach einem der Ansprüche 1 bis 5, dadurch gekennzeichnet, daß die Signalauskopplung am Emitter des Gegenkopplungstransistors (T1) erfolgt.

7) Empfangsverstärker nach einem der Ansprüche 1 bis 6, dadurch gekennzeichnet, daß zwischen den Kollektor des Gegenkopplungstransistors (T1) und das Betriebspotential ($U_B$) ein Widerstand (R3) geschaltet ist und daß der an diesem Widerstand (R3) hervorgerufene Spannungshub über den Transistor (T3), dessen Emitter-Kollektorstrecke in Serie zur Reihenschaltung aus einem Widerstand (R2) und dem lichtempfindlichen Halbleiterbauelement (FD) liegt, sowie über den in Reihe zum lichtempfindlichen Halbleiterbauelement liegenden Widerstand (R2) und die Koppelkapazität ($C_k$) der Basis des Verstärkertransistors (T2) zugeführt wird und somit die erforderliche $U_{BE}$-Änderung am Verstärkertransistor (T2) kompensiert.

FIG. 1